# EUROPÄISCHE PATENTSCHRIFT

(11) **EP 3 018 709 B1**
(45) Veröffentlichungstag und Bekanntmachung des Hinweises auf die Patenterteilung: **18.07.2018**
(21) Anmeldenummer: 14191672.6
(22) Anmeldetag: 04.11.2014
(51) Int. Cl.: H01L 23/40, H01L 23/467, H01L 25/07, H02M 1/00

(54) **Stromrichtereinrichtung**
Power converter
Dispositif de convertisseur

(43) Veröffentlichungstag der Anmeldung: 11.05.2016
(73) Patentinhaber: SEMIKRON Elektronik GmbH & Co. KG, 90431 Nürnberg (DE)
(72) Erfinder: Gaumon, Aurélien, 75009 Paris (FR); Meziti, Nabil, 95100 Argenteuil (FR); Touzard, Sébastien, 27420 Chateau-sur-epte (FR); Vanhyfte, Francois, 95360 Montmagny (FR)

(56) Entgegenhaltungen:
- EP-A1- 2 161 745
- WO-A1-2013/044409
- CH-A- 399 601
- CH-A- 414 873
- CH-A- 423 994
- DE-A1- 1 439 160
- DE-A1- 1 464 515
- DE-A1- 1 789 139
- JP-A- S57 166 062

## Beschreibung

Die Erfindung betrifft eine Stromrichtereinrichtung.

Aus der DE 10 2009 024 384 A1 ist eine Stromrichtereinrichtung in gestapelter Bauweise bekannt, bei der ein erstes und ein zweites Leistungshalbleiterbauelement zwischen Kühlkörpern eingeklemmt sind und mit den Kühlkörpern mittels Druckkontaktierung elektrisch verbunden sind. Die Kühlkörper sind dabei in einer axialen Richtung der Stromrichtereinrichtung übereinander angeordnet, wobei die Kühlrippen der Kühlkörper in axialer Richtung der Stromrichtereinrichtung verlaufen. Nachteilig bei einer solchen techniküblichen Stromrichtereinrichtung ist, dass bei der üblicherweise in vertikaler Richtung übereinander ausgeführten Anordnung der Kühlkörper, insbesondere der oberste Kühlkörper, relativ schlecht von der Umgebungsluft der Stromrichtereinrichtung gekühlt wird.

Aus der JP S 57 166 062 A ist eine Gleichrichtereinrichtung in gestapelter Bauweise bekannt, bei der Leistungshalbleiterbauelemente zwischen Kühlkörpern eingeklemmt sind.

Aus der CH 423 994 A ist eine Kühlanordnung für elektronische Bauelemente bekannt, bei dem mindestens drei Kühlelemente ein Gehäuse ausbilden.

Aus der CH 399 601 A ist eine Halbleiteranordnung, die aus mehreren auf Kühlerblöcken aufgebauten Halbleiterbauelementen, welche in einem Schrank zusammengebaut sind, bekannt.

Es ist Aufgabe der Erfindung eine kompakt aufgebaute Stromrichtereinrichtung zu schaffen, deren in einer axialen Richtung der Stromrichtereinrichtung hintereinander angeordneten Kühlkörper gut gekühlt werden.

Diese Aufgabe wird gelöst durch eine Stromrichtereinrichtung mit einem ersten und zweiten elektrisch leitenden Kühlkörper, die in einer axialen Richtung der Stromrichtereinrichtung hintereinander angeordnet sind, wobei der zweite Kühlkörper hinter dem ersten Kühlkörper angeordnet ist, wobei der erste und zweite Kühlkörper jeweilig einen zylinderförmigen Grundkörper und in axiale Richtung der Stromrichtereinrichtung verlaufende Kühlrippen aufweisen, die thermisch leitend mit dem Grundkörper verbunden sind, mit einem ersten Leistungshalbleiterbauelement, das zwischen den Grundkörpern des ersten und zweiten Kühlkörpers angeordnet ist,

mit einer Druckerzeugungseinrichtung, die den ersten und zweiten Kühlkörper und das erste Leistungshalbleiterbauelement gegeneinander drückt,
mit einer Verschalung, die die Kühlrippen des ersten und zweiten Kühlkörpers umschließt und solchermaßen einen Kühlkanal ausbildet in dem die Kühlrippen des ersten und zweiten Kühlkörpers angeordnet sind, wobei der erste Kühlkörper ein mit dem Grundkörper des ersten Kühlkörpers verbundenes, senkrecht zur axialen Richtung der Stromrichtereinrichtung verlaufendes und nach außerhalb der Verschalung führendes erstes Lastanschlusselement aufweist, wobei der zweite Kühlkörper ein mit dem Grundkörper des zweiten Kühlkörpers verbundenes, senkrecht zur axialen Richtung der Stromrichtereinrichtung verlaufendes und nach außerhalb der Verschalung führendes zweites Lastanschlusselement aufweist,
und mit einem Lüfter, der dazu ausgebildet ist, Luft durch den Kühlkanal entlang der Kühlrippen zu bewegen, wobei die Grundkörper des ersten und zweiten Kühlkörpers eine gemeinsame Zentralachse aufweisen, wobei die Verschalung auf einer um den jeweiligen Kühlkörper senkrecht zur axialen Richtung der Stromrichtereinrichtung verlaufenden Kreisbahn verläuft, wobei der Mittelpunkt des Kreises den die Kreisbahn beschreibt dabei auf der Zentralachse des jeweiligen zylinderförmigen Grundkörpers liegt.

Vorteilhafte Ausbildungen der Erfindung ergeben sich aus den abhängigen Ansprüchen.

Es erweist sich als vorteilhaft, wenn der erste Kühlkörper ein mit den Grundkörper des ersten Kühlkörpers verbundenes, senkrecht zur axialen Richtung der Stromrichtereinrichtung verlaufendes und nach außerhalb der Verschalung führendes erstes Lastparallelanschlusselement aufweist, das dem ersten Lastanschlusselement gegenüberliegend angeordnet ist, und dass der zweite Kühlkörper ein mit dem Grundkörper des zweiten Kühlkörpers verbundenes, senkrecht zur axialen Richtung der Stromrichtereinrichtung verlaufendes und nach außerhalb der Verschalung führendes zweites Lastparallelanschlusselement aufweist, das dem zweiten Lastanschlusselement gegenüberliegend angeordnet ist. Hierdurch können mehrere Stromrichtereinrichtungen auf einfache Art und Weise miteinander elektrisch leitend verbunden werden.

Weiterhin erweist es sich als vorteilhaft, wenn das zweite Lastanschlusselement bezüglich der axialen Richtung der Stromrichtereinrichtung um 90° gedreht gegenüber dem ersten Lastanschlusselement verläuft, da dann das zweite Lastanschlusselement leicht von außen zugänglich ist.

Weiterhin erweist es sich als vorteilhaft, wenn die Stromrichtereinrichtung einen elektrisch leitenden dritten Kühlköper aufweist, der in axialer Richtung der Stromrichtereinrichtung hinter dem zweiten Kühlkörper angeordnet ist, wobei der dritte Kühlkörper einen zylinderförmigen Grundkörper und in axiale Richtung der Stromrichtereinrichtung verlaufende Kühlrippen aufweist, die thermisch leitend mit dem Grundkörper verbunden sind, wobei die Stromrichtereinrichtung ein zweites Leistungshalbleiterbauelement aufweist, das zwischen den Grundkörpern des zweiten und des dritten Kühlkörpers angeordnet ist, wobei die Druckerzeugungseinrichtung, den ersten, zweiten und dritten Kühlkörper und das erste und zweite Leistungshalbleiterbauelement gegeneinander drückt, wobei die Verschalung die Kühlrippen des ersten, zweiten und dritten Kühlkörpers umschließt und solchermaßen einen Kühlkanal ausbildet in dem die Kühlrippen des ersten, zweiten und dritten Kühlkörpers angeordnet sind, wobei der dritte Kühlkörper ein mit dem Grundkörper des dritten Kühlkörpers verbundenes, senkrecht zur axialen Richtung der Stromrichtereinrichtung verlaufendes und nach außerhalb der Verschalung führendes drittes Lastanschlusselement aufweist. Hierdurch kann eine besonders kompakt aufgebaute Halbbrückenschaltung realisiert werden.

In diesem Zusammenhang erweist es sich als vorteilhaft, wenn der dritte Kühlkörper ein mit dem Grundkörper des dritten Kühlkörpers verbundenes, senkrecht zur axialen Richtung der Stromrichtereinrichtung verlaufendes und nach außerhalb der Verschalung führendes drittes Lastparallelanschlusselement aufweist, das dem dritten Lastanschlusselement gegenüberliegend angeordnet ist. Hierdurch können mehrere Stromrichtereinrichtungen auf einfache Art und Weise miteinander elektrisch leitend verbunden werden.

In diesem Zusammenhang erweist es sich als vorteilhaft, wenn das erste und dritte Lastanschlusselement parallel zueinander verlaufen, da dann mehrere Stromrichtereinrichtungen besonderes einfache Art und Weise miteinander elektrisch leitend verbunden werden können.

Ferner erweist es sich als vorteilhaft, wenn der erste, zweite und falls vorhanden der dritte Kühlkörper identisch ausgebildet sind, da dann die Stromrichtereinrichtung einfach und kostengünstig hergestellt werden, da dann nur wenige unterschiedliche Bauteile zur Herstellung der Stromrichtereinrichtung benötigt werden.

Ferner erweist es sich als vorteilhaft, wenn die Kühlrippen, die Lastanschlusselemente und falls vorhanden die Lastparallelanschlusselemente des jeweiligen Kühlköpers einstückig mit dem Grundkörper des jeweiligen Kühlköpers ausgebildet sind, da dann die Stromrichtereinrichtung besonders einfach und kostengünstig hergestellt werden, da dann nur sehr wenige Bauteile zur Herstellung der Stromrichtereinrichtung benötigt werden.

Weiterhin erweist es sich als vorteilhaft, wenn der zweite Kühlkörper aus einem ersten und einem zweiten Teilkühlkörper ausgebildet ist, wobei der Grundkörper des zweiten Kühlkörpers aus einem ersten und zweiten Teilgrundkörper ausgebildet ist und der erste Teilgrundkörper Bestandteil des ersten Teilkühlkörpers ist und der zweite Teilgrundkörper Bestandteil des zweiten Teilkühlkörpers ist, wobei der erste und zweite Teilkühlkörper in axialer Richtung der Stromrichtereinrichtung hintereinander angeordnet sind, wobei zwischen dem ersten und zweiten Teilkühlkörper ein elektrisch nicht leitendes Isolationselement angeordnet ist, wobei das zweite Lastanschlusselement mehrstückig ausgebildet ist und ein erstes und ein zweites Teillastanschlusselement aufweist, wobei das erste Teillastanschlusselement mit dem ersten Teilgrundkörper verbunden ist und das zweite Teillastanschlusselement mit dem zweiten Teilgrundkörper verbunden ist. Hierdurch wird ein voneinander elektrisch getrennter Zugang zu dem zweiten Lastromanschluss des ersten Leistungshalbleiterbauelements und dem ersten Lastromanschluss des zweiten Leistungshalbleiterbauelements ermöglicht.

In diesem Zusammenhang erweist es sich als vorteilhaft, wenn die die Stromrichtereinrichtung ein mit dem Grundkörper des zweiten Kühlkörpers verbundenes, senkrecht zur axialen Richtung der Stromrichtereinrichtung verlaufendes und nach außerhalb der Verschalung führendes zweites Lastparallelanschlusselement aufweist, das dem zweiten Lastanschlusselement gegenüberliegend angeordnet ist, wobei das zweite Lastparallelanschlusselement mehrstückig ausgebildet ist und ein erstes und ein zweites Teillastparallelanschlusselement aufweist, wobei das erste Teillastparallelanschlusselement mit dem ersten Teilgrundkörper verbunden ist und das zweite Teillastparallelanschlusselement mit dem zweiten Teilgrundkörper verbunden ist. Hierdurch können mehrere Stromrichtereinrichtungen auf einfache Art und Weise miteinander elektrisch leitend verbunden werden.

Weiterhin erweist es sich in diesem Zusammenhang als vorteilhaft, wenn der erste und dritte Kühlkörper identisch ausgebildet sind, da dann die Stromrichtereinrichtung einfach und kostengünstig hergestellt werden, da dann nur wenige unterschiedliche Bauteile zur Herstellung der Stromrichtereinrichtung benötigt werden.

Ferner erweist es sich als vorteilhaft, wenn dass der erste und zweite Teilkühlkörper identisch ausgebildet sind, da dann die Stromrichtereinrichtung einfach und kostengünstig hergestellt werden, da dann nur wenige unterschiedliche Bauteile zur Herstellung der Stromrichtereinrichtung benötigt werden.

Weiterhin erweist es sich als vorteilhaft, wenn der erste und dritte Kühlkörper und der erste und der zweite Teilkühlkörper alle identisch ausgebildet sind, da dann die Stromrichtereinrichtung besonders einfach und kostengünstig hergestellt werden, da dann nur sehr wenige unterschiedliche Bauteile zur Herstellung der Stromrichtereinrichtung benötigt werden.

Weiterhin erweist es sich als vorteilhaft, wenn die Kühlrippen, die Lastanschlusselemente und falls vorhanden die Lastparallelanschlusselemente des ersten und dritten Kühlköpers einstückig mit dem Grundkörper des jeweiligen Kühlköpers ausgebildet sind, und die Kühlrippen des ersten Teilkühlkörpers, das erste Teillastanschlusselement und falls vorhanden das erste Teillastparallelanschlusselement einstückig mit dem ersten Teilgrundkörper ausgebildet sind, und die Kühlrippen des zweiten Teilkühlkörpers, das zweite Teillastanschlusselement und falls vorhanden das zweite Teillastparallelanschlusselement einstückig mit dem zweiten Teilgrundkörper ausgebildet sind, da dann die Stromrichtereinrichtung besonders einfach und kostengünstig hergestellt werden, da dann nur sehr wenige Bauteile zur Herstellung der Stromrichtereinrichtung benötigt werden.

Weiterhin erweist es sich als vorteilhaft, wenn die Verschalung mehrstückig aus mehreren Verschalungssegmenten ausgebildet ist. Hierdurch wird eine einfache Ausbildung der Verschalung realisiert.

Weiterhin erweist es sich als vorteilhaft, wenn in axialer Richtung der Stromrichtereinrichtung verlaufende Außenkanten der Kühlrippen auf einer um den jeweiligen Kühlkörper senkrecht zur axialen Richtung der Stromrichtereinrichtung verlaufenden Kreisbahn angeordnet sind. Hierdurch wird eine platzsparender Ausbildung der Stromrichtereinrichtung erreicht.

Ferner erweist es sich als vorteilhaft, wenn die zylinderförmigen Grundkörper jeweilig als Hohlzylinder oder als aus einem Vollmaterial bestehenden Zylinder ausgebildet sind. Eine Ausbildung des zylinderförmigen Grundkörpers als Hohlzylinder ermöglicht eine besonderes leichte Ausbildung der Stromrichtereinrichtung. Eine Ausbildung des zylinderförmigen Grundkörpers als aus einem Vollmaterial bestehenden Zylinder ermöglicht eine besonders gute thermische Anbindung des jeweiligen Leistungshalbleiterbauelements an den Grundkörper.

Weiterhin erweist sich eine Stromrichteranordnung mit mehreren erfindungsgemäßen Stromrichtereinrichtungen, wobei die Stromrichtereinrichtungen jeweilig ein mit den Grundkörper des ersten Kühlkörpers verbundenes, senkrecht zur axialen Richtung der jeweiligen Stromrichtereinrichtung verlaufendes und nach außerhalb der Verschalung führendes erstes Lastparallelanschlusselement aufweist, das dem jeweiligen ersten Lastanschlusselement gegenüberliegend angeordnet ist, wobei die Stromrichtereinrichtungen in einer senkrecht zur axialen Richtung der Stromrichtereinrichtung verlaufenden Reihe hintereinander angeordnet sind und das jeweilige erste Lastanschlusselement der jeweiligen Stromrichtereinrichtung mit dem jeweiligen ersten Lastparallelanschlusselement der unmittelbar in der Reihe nachfolgenden jeweiligen Stromrichtereinrichtung elektrisch leitend verbunden ist, als vorteilhaft, da sich eine solche Stromrichteranordnung nur eine geringe Dicke aufweist.

Weiterhin erweist sich eine Stromrichteranordnung mit drei erfindungsgemäßen Stromrichtereinrichtungen, wobei die drei Stromrichtereinrichtungen jeweilig ein mit den Grundkörper des ersten Kühlkörpers verbundenes, senkrecht zur axialen Richtung der jeweiligen Stromrichtereinrichtung verlaufendes und nach außerhalb der Verschalung führendes erstes Lastparallelanschlusselement aufweist, das dem jeweiligen ersten Lastanschlusselement gegenüberliegend angeordnet ist, wobei die drei Stromrichtereinrichtungen auf den Eckpunkten eines gedachten gleichseitigen Dreiecks angeordnet sind, wobei im Uhrzeigersinn das jeweilige erste Lastanschlusselement der jeweiligen Stromrichtereinrichtung mit dem jeweiligen ersten Lastparallelanschlusselement der unmittelbar nachfolgenden jeweiligen Stromrichtereinrichtung elektrisch leitend verbunden ist, als vorteilhaft, da eine solche Stromrichtereinrichtung bezüglich ihrer parasitären Induktivitäten und parasitären Kapazitäten symmetrisch aufgebaut ist.

Ausführungsbeispiele der Erfindung sind in den Figuren dargestellt und werden im Folgenden näher erläutert. Dabei zeigen:
- FIG 1: eine erfindungsgemäße Stromrichtereinrichtung,
- FIG 2: eine erfindungsgemäße Stromrichtereinrichtung ohne Verschalung,
- FIG 3: eine Schnittansicht einer erfindungsgemäßen Stromrichtereinrichtung,
- FIG 4: eine weitere Schnittansicht einer erfindungsgemäßen Stromrichtereinrichtung,
- FIG 5: eine Stromrichteranordnung, die mehrere erfindungsgemäße Stromrichtereinrichtungen aufweist,
- FIG 6: eine Schnittansicht der in FIG 5 dargestellten Stromrichteranordnung, wobei nur die ersten und dritten Kühlkörper der Stromrichtereinrichtungen dargestellt sind,
- FIG 7: eine Schnittansicht einer weiteren Stromrichteranordnung, die mehrere erfindungsgemäße Stromrichtereinrichtungen aufweist, wobei nur ein erster und dritter Kühlkörper der Stromrichtereinrichtungen, sowie elektrisch leitende Verbindungselemente dargestellt sind,
- FIG 8: eine weitere Ausbildung einer erfindungsgemäßen Stromrichtereinrichtung,
- FIG 9: eine Schnittansicht einer weiteren Ausbildung einer erfindungsgemäßen Stromrichtereinrichtung,
- FIG 10: ein elektrisches Schaltbild einer erfindungsgemäßen Stromrichtereinrichtung und
- FIG 11: ein elektrisches Schaltbild einer weiteren Ausbildung einer erfindungsgemäßen Stromrichtereinrichtung.

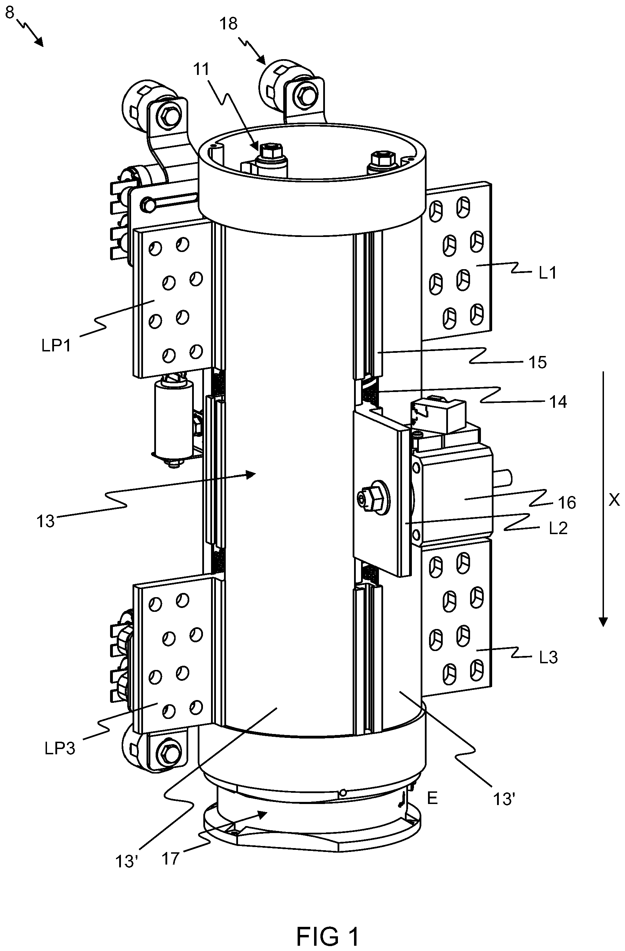

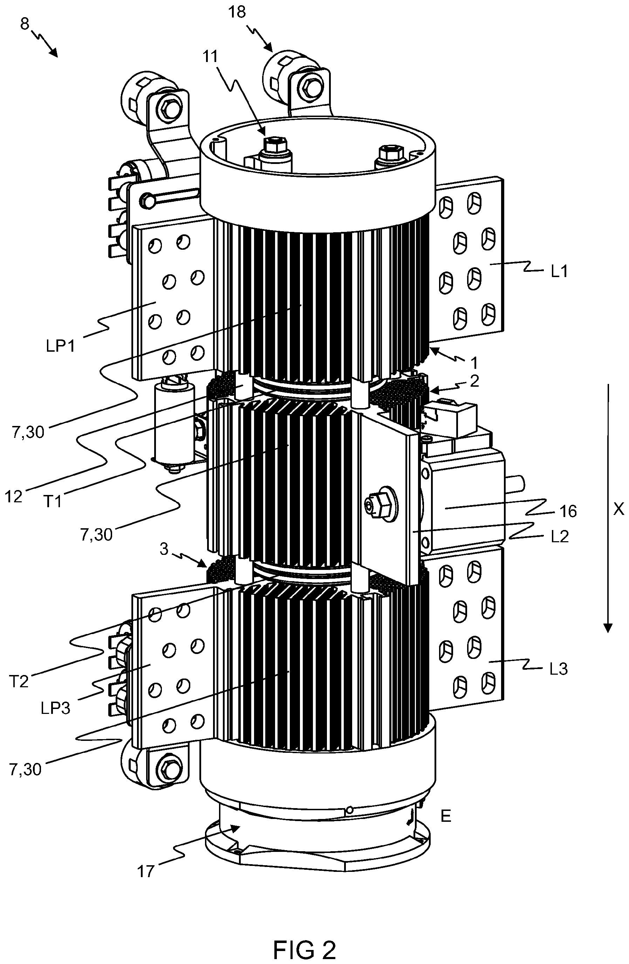

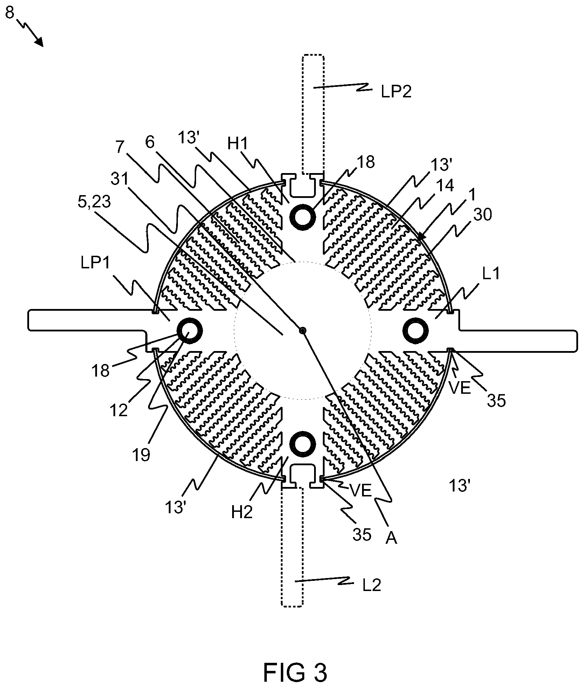

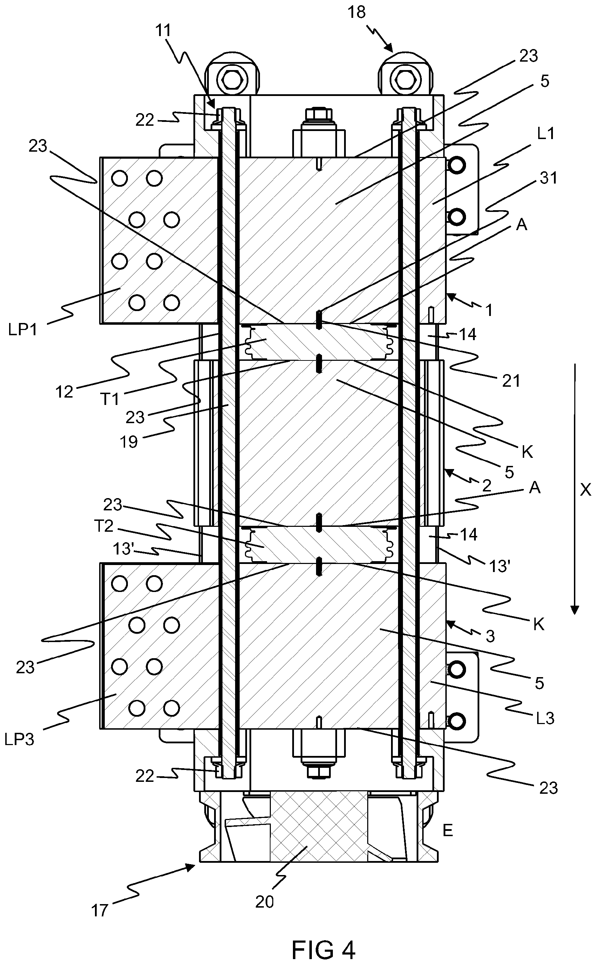

In FIG 1 und FIG 2 ist eine erfindungsgemäße Stromrichtereinrichtung 8 dargestellt, wobei in FIG 2 die Stromrichtereinrichtung 8 ohne Verschalung 13 dargestellt ist. In FIG 3 und FIG 4 sind Schnittansichten der erfindungsgemäßen Stromrichtereinrichtung 8 dargestellt.

Die erfindungsgemäße Stromrichtereinrichtung 8 weist einen elektrisch leitenden ersten, zweiten und dritten Kühlkörper 1, 2, 3, auf, die in einer axialen Richtung X der Stromrichtereinrichtung 8 hintereinander angeordnet sind, wobei der zweite Kühlkörper 2 hinter dem ersten Kühlkörper 1 angeordnet ist und der dritte Kühlkörper 3 hinter dem zweiten Kühlkörper 2 angeordnet ist. Der zweite Kühlkörper 2 ist somit zwischen dem ersten und dritten Kühlkörper 1 und 3 angeordnet. Der erste, zweite und dritte Kühlkörper 1, 2 und 3 sind vorzugsweise identisch ausgebildet. Der erste, zweite und dritte Kühlkörper 1, 2 und 3 weisen jeweilig einen zylinderförmigen Grundkörper 5 und in axiale Richtung X der Stromrichtereinrichtung 8 verlaufende Kühlrippen 7 auf. Die zylinderförmigen Grundkörper 5 können jeweilig als ein Hohlzylinder oder wie beim Ausführungsbeispiel als aus einem Vollmaterial bestehenden Zylinder ausgebildet sein. Vorzugsweise sind in axialer Richtung X der Stromrichtereinrichtung 8 verlaufende Außenkanten 30 der Kühlrippen 7 auf einer um den jeweiligen Kühlkörper senkrecht zur axialen Richtung X der Stromrichtereinrichtung 8 verlaufenden Kreisbahn angeordnet. Der Mittelpunkt des Kreises den die Kreisbahn beschreibt liegt dabei auf der Zentralachse A des jeweiligen zylinderförmigen Grundkörpers 5.

Der erste, zweite und dritte Kühlkörper 1, 2, 3 bestehen vorzugweise aus einem Metall, insbesondere aus Aluminium oder Kupfer bzw. insbesondere aus einer Aluminium- oder Kupferlegierung.

Weiterhin weist die Stromrichtereinrichtung 8 ein erstes und einem zweites Leistungshalbleiterbauelement T1 und T2 auf, wobei das erste Leistungshalbleiterbauelement T1 zwischen den Grundkörpern 5 des ersten und zweiten Kühlkörpers 1 und 2 angeordnet ist und das zweite Leistungshalbleiterbauelement T2 zwischen den Grundkörpern 5 des zweiten und dritten Kühlkörpers 2 und 3 angeordnet ist. Die Leistungshalbleiterbauelemente T1 und T2 liegen dabei im Allgemeinen in Form von Transistoren, wie z.B. IGBTs (Insulated Gate Bipolar Transistor) oder MOSFETs (Metal Oxide Semiconductor Field Effect Transistor) oder in Form von Thyristoren oder Dioden vor. Beim Ausführungsbeispiel liegen die Leistungshalbleiterbauelemente T1 und T2 in Form von Thyristoren vor, wobei der Übersichtlichkeitshalber die jeweilige elektrische Verbindung an das Gate der Thyristoren in den Figuren nicht dargestellt ist. Die jeweilige elektrischen Verbindung (z.B. Kabel) an das Gate der Thyristoren kann z.B. senkrecht zur axialen Richtung X der Stromrichtereinrichtung 8 an das jeweilige Leistungshalbleiterbauelement T1 bzw. T2 angeschlossen sein.

Die Grundkörper 5 und das erste und zweite Leistungshalbleiterbauelement T1 und T2 weisen vorzugsweise zur Fixierung und mittigen Anordnung der ersten und zweiten Leistungshalbleiterbauelemente T1 und T2 an in ihren axialen Enden in axiale Richtung X der Stromrichtereinrichtung 8 verlaufende zentral angeordnete Sacklöcher 31 auf in denen Fixierstife 21 angeordnet sind.

Weiterhin weist die erfindungsgemäße Stromrichtereinrichtung 8 eine Druckerzeugungseinrichtung 11, die den ersten, zweiten und dritten Kühlkörper 1, 2 und 3 und das erste und zweite Leistungshalbleiterbauelement T1 und T2 gegeneinander drückt. Hierdurch werden die axialen Endflächen 23 der Grundkörper 5 des ersten, zweiten und dritten Kühlkörper 1, 2 und 3 gegen die ersten und zweiten Laststromanschlüsse A und K des ersten und zweiten Thyristors T1 und T2 gedrückt und solchermaßen der erste und zweite Kühlkörper 1 und 2 mit den ersten und zweiten Lastromanschlüssen A und K des ersten Thyristors T1, und der zweite und dritte Kühlkörper 2 und 3 mit den ersten und zweiten Lastromanschlüssen A und K des zweiten Thyristors T2 druckkontaktiert und solchermaßen elektrisch verbunden. Im Rahmen des Ausführungsbeispiels ist der erste Lastromanschluss A des ersten und zweiten Thyristors T1 und T2 als Anode ausgebildet und der zweite Lastromanschluss K des ersten und zweiten Thyristors T1 und T2 als Kathode ausgebildet. Im Rahmen des Ausführungsbeispiels weist die Druckerzeugungseinrichtung 11 Schraubverbindungen auf, die den ersten, zweiten und dritten Kühlkörper 1, 2 und 3 und das erste und zweite Leistungshalbleiterbauelement T1 und T2 gegeneinander drücken. Die jeweilige Schraubverbindung besteht im Rahmen des Ausführungsbeispiels aus einem an seinen beiden axialen Enden mit einem Gewinde versehen Stift 19, der durch in axiale Richtung X der Stromrichtereinrichtung 8 verlaufende Durchgangslöcher 18 des ersten, zweiten und dritten Kühlkörpers 1, 2 und 3 hindurchverläuft, wobei an den axialen Enden des Stifts 19 Muttern 22 auf den Stift 19 aufgeschraubt sind. Der Druck auf die Kühlkörper 1, 2, und 3 und die Leistungshalbleiterbauelemente T1 und T2 wird durch Eindrehen der Muttern 22 erzeugt. Zur elektrischen Isolation ist zwischen dem ersten, zweiten und dritten Kühlkörper 1, 2, und 3 und dem Stift 19 eine Isolationshülse 12 aus einem elektrisch nicht leitenden Material (z.B. Keramik oder Kunststoff) angeordnet (siehe FIG 3). Der Stift 19 verläuft innerhalb der Isolationshülse 12.

Weiterhin weist die erfindungsgemäße Stromrichtereinrichtung 8 eine Verschalung 13 auf, die die Kühlrippen 7 des ersten, zweiten und dritten Kühlkörpers 1, 2 und 3 umschließt und solchermaßen einen Kühlkanal 14 ausbildet in dem die Kühlrippen 7 des ersten, zweiten und dritten Kühlkörper 1, 2 und 3 angeordnet sind. Die Verschalung 13 ist vorzugsweise mehrstückig aus mehreren Verschalungssegmenten 13' ausgebildet. Alternativ kann die Verschalung auch einstückig ausgebildet sein. Die Verschalung 13 bzw. die Verschalungssegmente 13' verlaufen auf einer um den jeweiligen Kühlkörper 1, 2 bzw. 3 senkrecht zur axialen Richtung X der Stromrichtereinrichtung 8 verlaufenden Kreisbahn. Der Mittelpunkt des Kreises den die Kreisbahn beschreibt liegt dabei auf der Zentralachse A des jeweiligen zylinderförmigen Grundkörpers 5.

Der erste Kühlkörper 1 weist ein mit dem Grundkörper 5 des ersten Kühlkörpers 1 verbundenes, senkrecht zur axialen Richtung X der Stromrichtereinrichtung 8 verlaufendes und nach außerhalb der Verschalung 13 führendes erstes Lastanschlusselement L1 auf. Der zweite Kühlkörper 2 weist ein mit dem Grundkörper 5 des zweiten Kühlkörpers 2 verbundenes, senkrecht zur axialen Richtung X der Stromrichtereinrichtung 8 verlaufendes und nach außerhalb der Verschalung 13 führendes zweites Lastanschlusselement L2 auf. Der dritte Kühlkörper 3 weist ein mit dem Grundkörper des dritten Kühlkörpers 3 verbundenes, senkrecht zur axialen Richtung X der Stromrichtereinrichtung 8 verlaufendes und nach außerhalb der Verschalung 13 führendes drittes Lastanschlusselement L3 auf.

Im Rahmen des Ausführungsbeispiels weist der erste Kühlkörper 1 ein mit den Grundkörper 5 des ersten Kühlkörpers 1 verbundenes, senkrecht zur axialen Richtung X der Stromrichtereinrichtung 8 verlaufendes und nach außerhalb der Verschalung 13 führendes erstes Lastparallelanschlusselement LP1 auf, das dem ersten Lastanschlusselement L1 in Bezug auf die Zentralachse A des Grundkörpers 5 des ersten Kühlkörpers 1 gegenüberliegend angeordnet ist, und der zweite Kühlkörper 2 weist ein mit dem Grundkörper 5 des zweiten Kühlkörpers 2 verbundenes, senkrecht zur axialen Richtung X der Stromrichtereinrichtung 8 verlaufendes und nach außerhalb der Verschalung 13 führendes zweites Lastparallelanschlusselement LP2 auf, das dem zweiten Lastanschlusselement L2 in Bezug auf die Zentralachse A des Grundkörpers 5 des zweiten Kühlkörpers 2 gegenüberliegend angeordnet ist, und der dritte Kühlkörper 3 weist ein mit dem Grundkörper 5 des dritten Kühlkörpers 3 verbundenes, senkrecht zur axialen Richtung X der Stromrichtereinrichtung 8 verlaufendes und nach außerhalb der Verschalung 13 führendes drittes Lastparallelanschlusselement LP3 auf, das dem dritten Lastanschlusselement L3 in Bezug auf die Zentralachse A des Grundkörpers 5 des dritten Kühlkörpers 3 gegenüberliegend angeordnet ist.

In FIG 3 verläuft der dargestellte Schnitt senkrecht zur axialen Richtung X der Stromrichtereinrichtung 8 durch den ersten Kühlkörper 1 hindurch, wobei das punktiert dargestellte zweite Lastanschlusselement L2 und das punktiert dargestellte zweite Lastparallelanschlusselement LP2 des zweiten Kühlkörpers 2 unterhalb der Schnittebene liegen. Die Lastanschlusselemente und Lastparallelanschlusselemente dienen zur elektrischen Verbindung der Stromrichtereinrichtung 8 mit einer weiteren Stromrichtereinrichtung 8 oder einem anderen externen Element. Die Durchgangslöcher 18 des ersten, zweiten und dritten Kühlkörpers 1, 2 und 3 verlaufen im Rahmen des Ausführungsbeispiels durch die Lastanschlusselemente und die Lastparallelanschlusselemente hindurch.

Der erste, zweite und dritte Kühlkörper 1, 2 und 3 weisen vorzugsweise jeweilig ein mit dem Grundkörpers 5 des jeweiligen Kühlkörpers verbundenes, senkrecht zur axialen Richtung X der Stromrichtereinrichtung 8 verlaufendes und vorzugsweise nach außerhalb der Verschalung 13 führendes, erstes und ein zweites Halteelement H1 und H2 auf (siehe FIG 3). Das zweite Haltelement H2 ist vorzugsweise dem ersten Halteelement H1 in Bezug auf die Zentralachse A des Grundkörpers 5 des jeweiligen Kühlkörpers gegenüberliegend angeordnet. Das erste Haltelement H1 ist vorzugsweise in Bezug auf die Zentralachse A des Grundkörpers 5 des jeweiligen Kühlkörpers gegenüber dem Lastanschlusselement des jeweiligen Kühlkörpers um 90° gedreht angeordnet. Im Rahmen des Ausführungsbeispiels verlaufen die Durchgangslöcher 18 des ersten, zweiten und dritten Kühlkörpers 1, 2 und 3 auch durch das erste und zweite Halteelement H1 und H2 hindurch. Das erste und ein zweite Halteelement, die Lastanschlusselemente und falls vorhanden die Lastparallelanschlusselemente der des ersten, zweiten und dritten Kühlkörpers 1, 2 und 3 weisen vorzugsweise in axiale Richtung X der Stromrichtereinrichtung 8 verlaufende Nuten 35 auf in denen in axiale Richtung X der Stromrichtereinrichtung 8 verlaufende Enden VE der Verschalungssegmente 13' angeordnet sind. Die Nuten 35 dienen als Führungen in axiale Richtung X der Stromrichtereinrichtung 8 für die Verschalungssegmente 13'.

Die Kühlrippen 7 des ersten, zweiten und dritten Kühlkörpers 1, 2 und 3 sind thermisch leitend mit dem Grundkörper 5 des jeweiligen Kühlkörpers verbunden. Die thermisch leitende Verbindung zwischen den Kühlrippen 7 des ersten, zweiten und dritten Kühlkörper 1, 2 und 3 und dem Grundkörper 5 des jeweiligen Kühlkörpers kann dabei sowohl z.B. durch eine direkte Verbindung der Kühlrippen 7 z.B. mit der Mantelfläche des Grundkörpers 5 des jeweiligen Kühlkörpers realisiert sein als auch durch eine indirekte Verbindung der Kühlrippen 7 mit dem Grundkörpers des jeweiligen Kühlkörpers, indem z.B. die Kühlrippen 7 mit dem Lastanschlusselement und/oder mit dem Lastparallelanschlusselement und/oder mit dem ersten Halteelement H1 und/oder mit dem ersten Halteelement H2 verbunden sind. Vorzugsweise ist zumindest ein Teil der Kühlrippen 7 des jeweiligen Kühlkörpers 1, 2 bzw. 3 an der Mantelfläche des Grundkörpers 5 des jeweiligen Kühlkörpers 1, 2 bzw. 3 angeordnet.

Im Rahmen des Ausführungsbeispiels ist eine Überstromsicherung 16 mit dem zweiten Lastanschlusselement L2 verbunden.

Vorzugsweise verlaufen das erste und dritte Lastanschlusselement L1 und L3 parallel zueinander und das zweite Lastanschlusselement L2 ist vorzugsweise bezüglich der axialen Richtung X der Stromrichtereinrichtung 8 um 90° gedreht gegenüber dem ersten Lastanschlusselement L1 angeordnet. Im Rahmen dieses Ausführungsbeispiels sind der erste, zweite und dritte Kühlkörper 1, 2 und 3 identisch ausgebildet, wobei der erste und dritte Kühlkörper 1 und 3 parallel zueinander ausgerichtet sind und der zweite Kühlkörper 2 bezüglich der axialen Richtung X der Stromrichtereinrichtung 8 um 90° gedreht gegenüber dem ersten und dritten Kühlkörper 1 und 3 angeordnet ist.

Die Kühlrippen 7, die Lastanschlusselemente L1, L2 bzw. L3 und falls vorhanden die Lastparallelanschlusselemente LP1, LP2 bzw. LP3 des jeweiligen Kühlköpers 1, 2, bzw. 3 sind vorzugsweise einstückig mit dem Grundkörper 5 des jeweiligen Kühlköpers 1, 2 bzw. 3 ausgebildet.

Weiterhin weist die erfindungsgemäße Stromrichtereinrichtung 8 einen Lüfter 17 auf, der dazu ausgebildet ist, Luft durch den Kühlkanal 14 entlang der Kühlrippen 7 zu bewegen. Der Lüfter 17 ist vorzugsweise an einem axialen Ende E der Stromrichtereinrichtung 8 fluchtet zum Kühlkanal 14 angerordnet. Im Rahmen des Ausführungsbeispiels weist der Lüfter 17 ein im Betrieb des Lüfters 17 drehendes Lüfterrad 20 auf.

Das Zusammenwirken der in axialer Richtung X der Stromrichtereinrichtung 8 verlaufenden Kühlrippen 7 mit der einen Kühlkanal 14 bildenden Verschalung 13 und dem durch den Kühlkanal 14 Luft entlang der Kühlrippen7 bewegenden Lüfter 17 wird eine sehr gute Kühlung der Kühlkörper und somit der Leistungshalbleiterbauelemente der Stromrichtereinrichtung 8 erzielt. Die Stromrichtereinrichtung 8 ist dabei sehr kompakt aufgebaut.

Wenn der erste, zweite und dritte Kühlkörper 1, 2 und 3 jeweilig einstückig ausgebildet sind und insbesondere der erste, zweite und dritte Kühlkörper 1, 2 und 3 identisch ausgebildet sind, kann die Stromrichtereinrichtung 8 besonderes einfach und kostengünstig hergestellt werden, da nur sehr wenige unterschiedliche Bauteile zur Herstellung der Stromrichtereinrichtung 8 benötigt werden. Der erste, zweite und dritte Kühlkörper 1, 2 und 3 können dabei besonderes einfach und kostengünstig, z.B. mittels eines Strangpressverfahrens, hergestellt sein.

Die Stromrichtereinrichtung 8 weist vorzugsweise mechanische Anschlussstellen 18 auf, über die die Stromrichtereinrichtung 8 mit einem externen Element, wie z.B. einem Rahmen oder einem Schaltschank mechanisch verbunden werden kann.

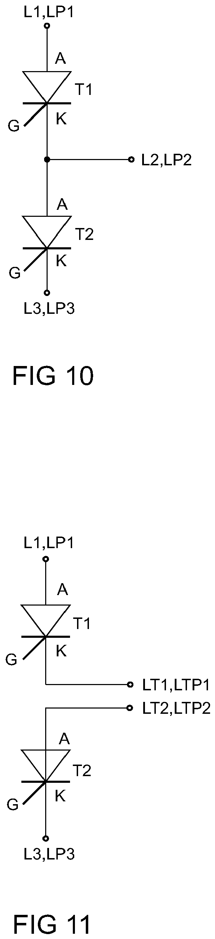

In FIG 10 ist ein elektrisches Schaltbild der erfindungsgemäßen Stromrichtereinrichtung 8 dargestellt. Die Stromrichtereinrichtung 8 bildet im Rahmen des Ausführungsbeispiels eine sogenannte Halbbrückenschaltung aus. Das erste und zweite Leistungshalbleiterbauelement T1 und T2 sind mittels des ersten, zweiten und dritten Kühlkörpers 1, 2 und 3 zu einer Halbbrückenschaltung verschalten.

Es sei angemerkt, das verallgemeinert im einfachsten Fall bei der erfindungsgemäßen Stromrichtereinrichtung 8 der dritte Kühlkörper 3 und das zweite Leistungshalbleiterbauelement T2 entfallen können. Weiterhin sei angemerkt, dass bei der erfindungsgemäßen Stromrichtereinrichtung 8 selbstverständlich in axiale Richtung X der Stromrichtereinrichtung 8 hinter dem dritten Kühlkörper in analoger Weise noch weitere Kühlkörper, zwischen denen jeweilig ein Leistungshalbleiterbauelement in analoger Weise angeordnet ist, angeordnet sein können. Die erfindungsgemäße Stromrichtereinrichtung 8 kann somit in axialer Richtung X der Stromrichtereinrichtung 8 erweitert sein.

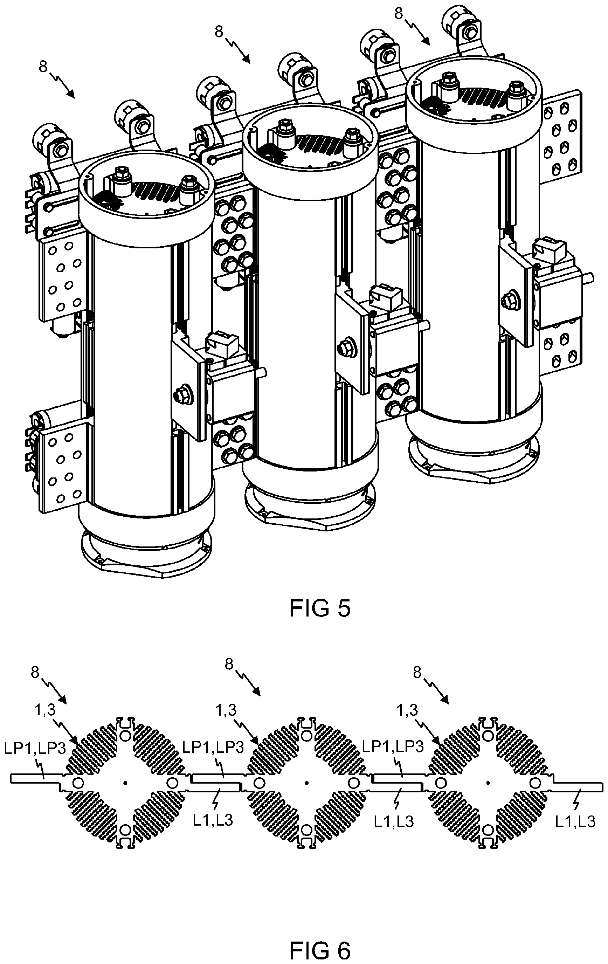

In FIG 5 ist eine Stromrichteranordnung, die mehrere erfindungsgemäße Stromrichtereinrichtungen 8 aufweist, dargestellt. In FIG 6 ist eine Schnittansicht der in FIG 5 dargestellten Stromrichteranordnung dargestellt, wobei nur die ersten und dritten Kühlkörper 1 und 3 der Stromrichtereinrichtungen 8 dargestellt sind. In FIG 6 sind dabei in einer Zeichnung zwei Schnitte dargestellt und zwar einmal in waagrechte Richtung durch die ersten Kühlkörper 1 der Stromrichtereinrichtungen 8 und durch die dritten Kühlkörper 3 der Stromrichtereinrichtungen 8. Die beiden Schnitte sind identisch, so dass sie in einer gemeinsamen Zeichnung dargestellt sind, wobei die Schnitte mit ihren jeweiligen Bezugszeichen versehen sind. Bei der in FIG 5 dargestellten Stromrichteranordnung sind mehrere (im konkreten Ausführungsbeispiel drei) erfindungsgemäße Stromrichtereinrichtungen 8 elektrisch parallel geschalten. Die Halbbrückenschaltungen, welche durch die Stromrichtereinrichtungen 8 ausgebildet werden, sind somit im Rahmen des Ausführungsbeispiels elektrisch parallel zu einem Stromrichter, welcher zum Gleich- und Wechselrichten von elektrischen Spannungen und Strömen verwendet werden kann, verschalten.

Die Stromrichtereinrichtungen 8 sind in einer senkrecht zur axialen Richtung X der Stromrichtereinrichtung 8 verlaufenden Reihe hintereinander angeordnet und das jeweilige erste Lastanschlusselement L1 der jeweiligen Stromrichtereinrichtung 8 ist mit dem jeweiligen ersten Lastparallelanschlusselement LP1 der unmittelbar in der Reihe nachfolgenden jeweiligen Stromrichtereinrichtung 8 elektrisch leitend verbunden, wobei vorzugsweise das jeweilige erste Lastanschlusselement L1 der jeweiligen Stromrichtereinrichtung 8 mit dem jeweiligen ersten Lastparallelanschlusselement LP1 der unmittelbar in der Reihe nachfolgenden jeweiligen Stromrichtereinrichtung 8 direkt verbunden ist. Weiterhin ist vorzugsweise, wie im Ausführungsbeispiel, das jeweilige dritte Lastanschlusselement L3 der jeweiligen Stromrichtereinrichtung 8 mit dem jeweiligen dritten Lastparallelanschlusselement LP3 der unmittelbar in der Reihe nachfolgenden jeweiligen Stromrichtereinrichtung 8 elektrisch leitend verbunden, wobei vorzugsweise das jeweilige dritte Lastanschlusselement L3 der jeweiligen Stromrichtereinrichtung 8 mit dem jeweiligen dritten Lastparallelanschlusselement LP3 der unmittelbar in der Reihe nachfolgenden jeweiligen Stromrichtereinrichtung 8 direkt verbunden ist. Die ersten und dritten Lastanschlusselemente L1 und L3 und die ersten und dritten Lastparallelanschlusselemente LP1 und LP3 dienen beim Ausführungsbeispiel als Gleichspannungspotentialanschlusselemente und die zweiten Lastanschlusselemente L2 und die zweiten Lastparallelanschlusselemente LP2 dienen beim Ausführungsbeispiel als Wechselspannungspotentialanschlusselemente.

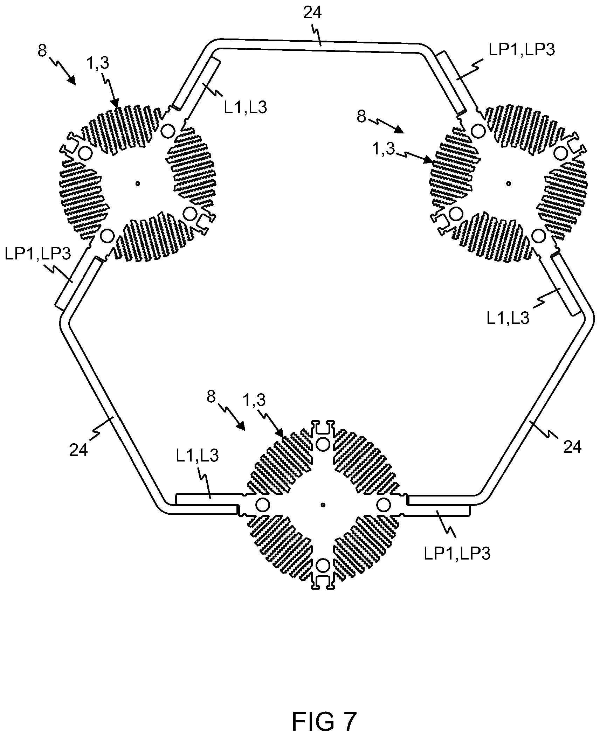

In FIG 7 ist eine Schnittansicht einer weiteren Stromrichteranordnung, die mehrere erfindungsgemäße Stromrichtereinrichtungen 8 aufweist, dargestellt, wobei nur der erste und dritte Kühlkörper 1 und 3 der Stromrichtereinrichtungen 8, sowie elektrisch leitende Verbindungselemente 24 dargestellt sind. In FIG 7 sind dabei in einer Zeichnung zwei Schnitte dargestellt und zwar einmal in waagrechte Richtung durch die ersten Kühlkörper 1 der Stromrichtereinrichtungen 8 und durch die dritten Kühlkörper 3 der Stromrichtereinrichtungen 8. Die beiden Schnitte sind identisch, so dass sie in einer gemeinsamen Zeichnung dargestellt sind, wobei die Schnitte mit ihren jeweiligen Bezugszeichen versehen sind. Bei der in FIG 5 dargestellten Stromrichteranordnung sind drei erfindungsgemäße Stromrichtereinrichtungen 8 mittels Verbindung ihrer ersten und dritten Lastanschlusselementen L1 und L3 und ihrer ersten und dritten Lastparallelanschlusselemente LP1 und LP3 über elektrisch leitende Verbindungselemente 24 elektrisch parallel geschalten. Die Halbbrückenschaltungen, welche durch die Stromrichtereinrichtungen 8 ausgebildet werden, sind somit im Rahmen des Ausführungsbeispiels elektrisch parallel zu einem Stromrichter, welcher zum Gleich- und Wechselrichten von elektrischen Spannungen und Strömen verwendet werden kann, verschalten.

Die drei Stromrichtereinrichtungen 8 sind auf den Eckpunkten eines gedachten gleichseitigen Dreiecks angeordnet, wobei im Uhrzeigersinn das jeweilige erste Lastanschlusselement L1 der jeweiligen Stromrichtereinrichtung 8 mit dem jeweiligen ersten Lastparallelanschlusselement LP1 der unmittelbar nachfolgenden jeweiligen Stromrichtereinrichtung 8 elektrisch leitend verbunden ist und das jeweilige dritte Lastanschlusselement L3 der jeweiligen Stromrichtereinrichtung 8 mit dem jeweiligen dritten Lastparallelanschlusselement LP3 der unmittelbar nachfolgenden jeweiligen Stromrichtereinrichtung 8 elektrisch leitend verbunden ist. Die elektrisch leitenden Verbindungen zwischen den Stromrichtereinrichtungen 8 sind dabei über elektrisch leitende Verbindungselemente 24 realisiert. Die ersten und dritten Lastanschlusselemente L1 und L3 und die ersten und dritten Lastparallelanschlusselemente LP1 und LP3 dienen beim Ausführungsbeispiel als Gleichspannungspotentialanschlusselemente und die zweiten Lastanschlusselemente L2 und die zweiten Lastparallelanschlusselemente LP2 als Wechselspannungspotentialanschlusselemente.

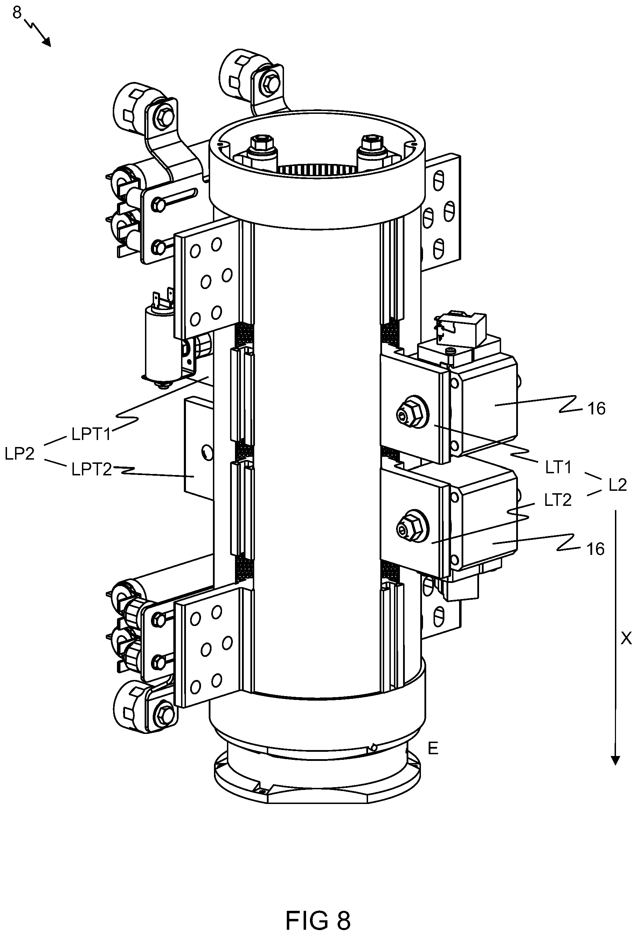

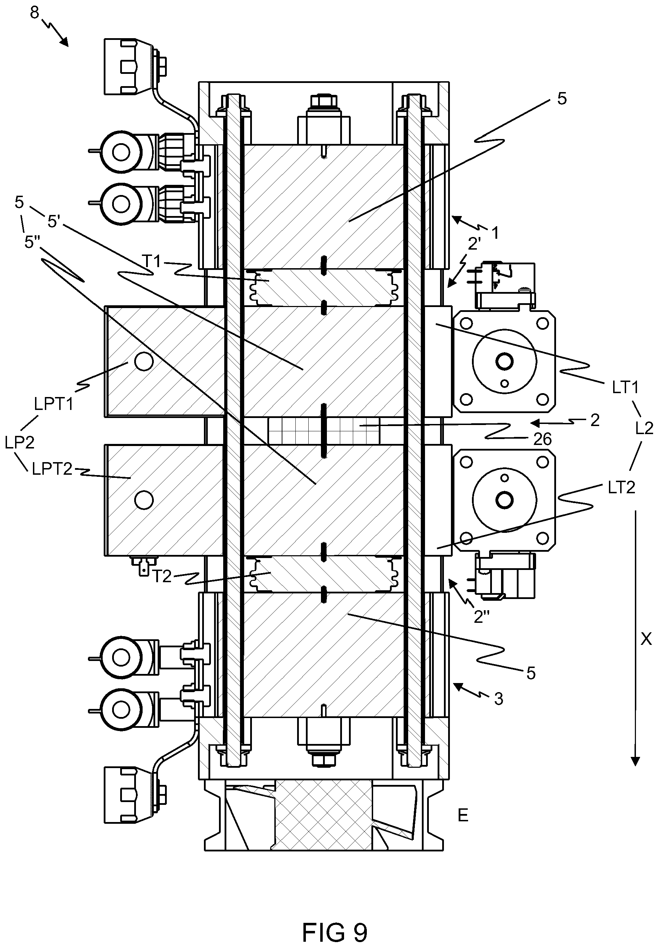

In FIG 8 ist eine weitere Ausbildung der erfindungsgemäßen Stromrichtereinrichtung 8 dargestellt. In FIG 9 ist eine Schnittansicht der weiteren Ausbildung der erfindungsgemäßen Stromrichtereinrichtung 8 dargestellt. In FIG 11 ist ein elektrisches Schaltbild der weiteren Ausbildung der erfindungsgemäßen Stromrichtereinrichtung 8 dargestellt.

Die erfindungsgemäße Stromrichtereinrichtung 8 gemäß den Figuren 8, 9 und 11 stimmt mit der zuvor beschriebenen erfindungsgemäßen Stromrichtereinrichtung 8 gemäß der Figuren 1 bis 7 und 10 bis auf die Merkmale überein, dass der zweite Kühlkörper 2 aus einem ersten und einem zweiten Teilkühlkörper 2' und 2" ausgebildet ist, wobei der Grundkörper 5 des zweiten Kühlkörpers 2 aus einem ersten und zweiten Teilgrundkörper 5' und 5" ausgebildet ist und der erste Teilgrundkörper 5' Bestandteil des ersten Teilkühlkörpers 2' ist und der zweite Teilgrundkörper 5" Bestandteil des zweiten Teilkühlkörpers 2" ist, wobei der erste und zweite Teilkühlkörper 2' und 2" in axialer Richtung X der Stromrichtereinrichtung 8 hintereinander angeordnet sind, wobei zwischen dem ersten und zweiten Teilkühlkörper 2' und 2" ein elektrisch nicht leitendes Isolationselement 26 angeordnet ist, wobei das zweite Lastanschlusselement L2 mehrstückig ausgebildet ist und ein erstes und ein zweites Teillastanschlusselement LT1 und LT2 aufweist, wobei das erste Teillastanschlusselement LT1 mit dem ersten Teilgrundkörper 5' verbunden ist und das zweite Teillastanschlusselement LT2 mit dem zweiten Teilgrundkörper 5" verbunden ist, und dass das zweite Lastparallelanschlusselement LP2 mehrstückig ausgebildet ist und ein erstes und ein zweites Teillastparallelanschlusselement LPT 1 und LPT2 aufweist, wobei das erste Teillastparallelanschlusselement LPT1 mit dem ersten Teilgrundkörper 5' verbunden ist und das zweite Teillastparallelanschlusselement LPT2 mit dem zweiten Teilgrundkörper 5" verbunden ist. Das erste und zweite Teillastanschlusselement LT1 und LT2 sind solchermaßen voneinander elektrisch isoliert angeordnet. Weiterhin sind solchermaßen das erste und das zweite Teillastparallelanschlusselement LPT1 und LPT2 voneinander elektrisch isoliert angeordnet.

Vorzugsweise sind der erste und zweite Teilkühlkörper 2 und 2' identisch ausgebildet. Weiterhin sind vorzugsweise der erste und dritte Kühlkörper 1 und 3 identisch ausgebildet.

Besonders vorteilhaft ist es, wenn der erste und dritte Kühlkörper 1 und 3 und der erste und der zweite Teilkühlkörper 2' und 2" alle identisch ausgebildet sind (in den Figuren nicht dargestellt). In diesem Fall wird nur ein einziger Typ von Kühlkörpern für die Stromrichtereinrichtung 8 benötigt.

Im Rahmen des Ausführungsbeispiels ist jeweilig eine Überstromsicherung 16 mit dem ersten und zweiten Teillastanschlusselement LT1 und LT2 verbunden. Die weitere Ausbildung der erfindungsgemäßen Stromrichtereinrichtung 8 hat den Vorteil, das dem ersten und zweiten Leistungshalbleiterbauelement T1 und T2 jeweilig eine Überstromsicherung 16 zugeordnet ist. Vorzugsweise werden die ersten und zweiten Teillastanschlusselemente LT1 und LT2 elektrisch nach den Überstromsicherungen 16 miteinander elektrisch leitend verbunden, so dass sich eine Halbbrückenschaltung ausbildet.

Es sei an dieser Stelle allgemein angemerkt, dass die Grundkörper 5 des ersten, zweiten und vorzugsweise falls vorhanden des dritten Kühlkörpers 1, 2 und 3 eine gemeinsame Zentralachse A aufweisen.

Weiterhin sei an dieser Stelle angemerkt, dass selbstverständlich Merkmale von verschiedenen Ausführungsbeispielen der Erfindung, sofern sich die Merkmale nicht gegenseitig ausschließen, beliebig miteinander kombiniert werden können.

## Patentansprüche

1. Stromrichtereinrichtung mit einem ersten und zweiten elektrisch leitenden Kühlkörper (1,2), die in einer axialen Richtung (X) der Stromrichtereinrichtung (8) hintereinander angeordnet sind, wobei der zweite Kühlkörper (2) hinter dem ersten Kühlkörper (1) angeordnet ist, wobei der erste und zweite Kühlkörper (1,2) jeweilig einen zylinderförmigen Grundkörper (5) und in axiale Richtung (X) der Stromrichtereinrichtung (8) verlaufende Kühlrippen (7) aufweisen, die thermisch leitend mit dem Grundkörper (5) verbunden sind,
mit einem ersten Leistungshalbleiterbauelement (T1), das zwischen den Grundkörpern (1,2) des ersten und zweiten Kühlkörpers (1,2) angeordnet ist, mit einer Druckerzeugungseinrichtung (11), die den ersten und zweiten Kühlkörper (1,2) und das erste Leistungshalbleiterbauelement (T1) gegeneinander drückt,
mit einer Verschalung (13), die die Kühlrippen (7) des ersten und zweiten Kühlkörpers (1,2) umschließt und solchermaßen einen Kühlkanal (14) ausbildet in dem die Kühlrippen (7) des ersten und zweiten Kühlkörpers (1,2) angeordnet sind, wobei der erste Kühlkörper (1) ein mit dem Grundkörper (5) des ersten Kühlkörpers (1) verbundenes, senkrecht zur axialen Richtung (X) der Stromrichtereinrichtung (8) verlaufendes und nach außerhalb der Verschalung (13) führendes erstes Lastanschlusselement (L1) aufweist, wobei der zweite Kühlkörper (2) ein mit dem Grundkörper (5) des zweiten Kühlkörpers (2) verbundenes, senkrecht zur axialen Richtung (X) der Stromrichtereinrichtung (8) verlaufendes und nach außerhalb der Verschalung (13) führendes zweites Lastanschlusselement (L2) aufweist,
**dadurch gekennzeichnet, dass** die Stromrichtereinrichtung einen Lüfter (17) aufweist, der dazu ausgebildet ist, Luft durch den Kühlkanal (14) entlang der Kühlrippen (7) zu bewegen, wobei die Grundkörper (5) des ersten und zweiten Kühlkörpers (1,2) eine gemeinsame Zentralachse (A) aufweisen, wobei die Verschalung (13) auf einer um den jeweiligen Kühlkörper (1,2) senkrecht zur axialen Richtung (X) der Stromrichtereinrichtung (8) verlaufenden Kreisbahn verläuft, wobei der Mittelpunkt des Kreises den die Kreisbahn beschreibt dabei auf der Zentralachse (A) des jeweiligen zylinderförmigen Grundkörpers (5) liegt.

2. Stromrichtereinrichtung nach Anspruch 1, **dadurch gekennzeichnet, dass** der erste Kühlkörper (1) ein mit den Grundkörper (5) des ersten Kühlkörpers (1) verbundenes, senkrecht zur axialen Richtung (X) der Stromrichtereinrichtung (8) verlaufendes und nach außerhalb der Verschalung (13) führendes erstes Lastparallelanschlusselement (LP1) aufweist, das dem ersten Lastanschlusselement (L1) gegenüberliegend angeordnet ist, und dass der zweite Kühlkörper (2) ein mit dem Grundkörper (5) des zweiten Kühlkörpers (2) verbundenes, senkrecht zur axialen Richtung (X) der Stromrichtereinrichtung (8) verlaufendes und nach außerhalb der Verschalung (13) führendes zweites Lastparallelanschlusselement (LP2) aufweist, das dem zweiten Lastanschlusselement (L2) gegenüberliegend angeordnet ist.

3. Stromrichtereinrichtung nach einem der vorhergehenden Ansprüche, **dadurch gekennzeichnet, dass** die Stromrichtereinrichtung (8) einen elektrisch leitenden dritten Kühlköper (3) aufweist, der in axialer Richtung (X) der Stromrichtereinrichtung (8) hinter dem zweiten Kühlkörper (2) angeordnet ist, wobei der dritte Kühlkörper (3) einen zylinderförmigen Grundkörper (5) und in axiale Richtung (X) der Stromrichtereinrichtung (8) verlaufende Kühlrippen (7) aufweist, die thermisch leitend mit dem Grundkörper (5) verbunden sind, wobei die Stromrichtereinrichtung (8) ein zweites Leistungshalbleiterbauelement (T2) aufweist, das zwischen den Grundkörpern (5) des zweiten und des dritten Kühlkörpers (2,3) angeordnet ist, wobei die Druckerzeugungseinrichtung (11), den ersten, zweiten und dritten Kühlkörper (1,2,3) und das erste und zweite Leistungshalbleiterbauelement (T1 ,T2) gegeneinander drückt, wobei die Verschalung (13) die Kühlrippen (5) des ersten, zweiten und dritten Kühlkörpers (1,2,3) umschließt und solchermaßen einen Kühlkanal (14) ausbildet in dem die Kühlrippen des ersten, zweiten und dritten Kühlkörpers (1,2,3) angeordnet sind, wobei der dritte Kühlkörper (3) ein mit dem Grundkörper (5) des dritten Kühlkörpers (3) verbundenes, senkrecht zur axialen Richtung (X) der Stromrichtereinrichtung (8) verlaufendes und nach außerhalb der Verschalung (13) führendes drittes Lastanschlusselement (L3) aufweist.

4. Stromrichtereinrichtung nach Anspruch 3, **dadurch gekennzeichnet, dass** der dritte Kühlkörper (3) ein mit dem Grundkörper (5) des dritten Kühlkörpers (3) verbundenes, senkrecht zur axialen Richtung (X) der Stromrichtereinrichtung (8) verlaufendes und nach außerhalb der Verschalung (13) führendes drittes Lastparallelanschlusselement (LP3) aufweist, das dem dritten Lastanschlusselement (L3) gegenüberliegend angeordnet ist.

5. Stromrichtereinrichtung nach einem der vorhergehenden Ansprüche, **dadurch gekennzeichnet, dass** der erste, zweite und falls vorhanden der dritte Kühlkörper (1,2,3) identisch ausgebildet sind.

6. Stromrichtereinrichtung nach einem der vorhergehenden Ansprüche, **dadurch gekennzeichnet, dass** die Kühlrippen (7), die Lastanschlusselemente (L1,L2,L3) und falls vorhanden die Lastparallelanschlusselemente (LP1,LP2,LP3) des jeweiligen Kühlköpers (1,2,3) einstückig mit dem Grundkörper (5) des jeweiligen Kühlköpers (1,2,3) ausgebildet sind.

7. Stromrichtereinrichtung nach Anspruch 3 oder 4, **dadurch gekennzeichnet, dass** der zweite Kühlkörper (2) aus einem ersten und einem zweiten Teilkühlkörper (2',2") ausgebildet ist, wobei der Grundkörper (5) des zweiten Kühlkörpers (2) aus einem ersten und zweiten Teilgrundkörper (5',5") ausgebildet ist und der erste Teilgrundkörper (5') Bestandteil des ersten Teilkühlkörpers (2') ist und der zweite Teilgrundkörper (5") Bestandteil des zweiten Teilkühlkörpers (2") ist, wobei der erste und zweite Teilkühlkörper (2',2") in axialer Richtung (X) der Stromrichtereinrichtung (8) hintereinander angeordnet sind, wobei zwischen dem ersten und zweiten Teilkühlkörper (2',2") ein elektrisch nicht leitendes Isolationselement (26) angeordnet ist, wobei das zweite Lastanschlusselement (L2) mehrstückig ausgebildet ist und ein erstes und ein zweites Teillastanschlusselement (LT1,LT2) aufweist, wobei das erste Teillastanschlusselement (LT1) mit dem ersten Teilgrundkörper (5') verbunden ist und das zweite Teillastanschlusselement (LT2) mit dem zweiten Teilgrundkörper (5") verbunden ist.

8. Stromrichtereinrichtung nach Anspruch 7, **dadurch gekennzeichnet, dass** die Stromrichtereinrichtung (8) ein mit dem Grundkörper (5) des zweiten Kühlkörpers (2) verbundenes, senkrecht zur axialen Richtung (X) der Stromrichtereinrichtung verlaufendes und nach außerhalb der Verschalung (13) führendes zweites Lastparallelanschlusselement (LP2) aufweist, das dem zweiten Lastanschlusselement (L2) gegenüberliegend angeordnet ist, wobei das zweite Lastparallelanschlusselement (LP2) mehrstückig ausgebildet ist und ein erstes und ein zweites Teillastparallelanschlusselement (LPT1,LPT2) aufweist, wobei das erste Teillastparallelanschlusselement (LT1) mit dem ersten Teilgrundkörper (5') verbunden ist und das zweite Teillastparallelanschlusselement (LTP2) mit dem zweiten Teilgrundkörper (5") verbunden ist.

9. Stromrichtereinrichtung nach Anspruch 7 oder 8, **dadurch gekennzeichnet, dass** der erste und dritte Kühlkörper (1,3) identisch ausgebildet sind.

10. Stromrichtereinrichtung nach Anspruch 7, 8 oder 9, **dadurch gekennzeichnet, dass** der erste und zweite Teilkühlkörper (2',2") identisch ausgebildet sind.

11. Stromrichtereinrichtung einem der Ansprüche 7 bis 10, **dadurch gekennzeichnet, dass** die Kühlrippen (7), die Lastanschlusselemente (L1,L3) und falls vorhanden die Lastparallelanschlusselemente (LP1,LP3) des ersten und dritten Kühlköpers (1,3) einstückig mit dem Grundkörper (5) des jeweiligen Kühlköpers (1,3) ausgebildet sind, und dass die Kühlrippen (7) des ersten Teilkühlkörpers (2'), das erste Teillastanschlusselement (LT1) und falls vorhanden das erste Teillastparallelanschlusselement (LTP1) einstückig mit dem ersten Teilgrundkörper (5') ausgebildet sind, und dass die Kühlrippen (7) des zweiten Teilkühlkörpers (2"), das zweite Teillastanschlusselement (LT2) und falls vorhanden das zweite Teillastparallelanschlusselement (LTP2) einstückig mit dem zweiten Teilgrundkörper (5") ausgebildet sind.

12. Stromrichtereinrichtung einem der vorhergehenden Ansprüche, **dadurch gekennzeichnet, dass** die Verschalung (13) mehrstückig aus mehreren Verschalungssegmenten (13') ausgebildet ist.

13. Stromrichtereinrichtung nach einem der vorhergehenden Ansprüche, **dadurch gekennzeichnet, dass** die zylinderförmigen Grundkörper (5) jeweilig als Hohlzylinder oder als aus einem Vollmaterial bestehenden Zylinder ausgebildet sind.

14. Stromrichteranordnung mit mehreren Stromrichtereinrichtungen, die nach einem der vorhergehenden Ansprüche ausgebildet sind, wobei die Stromrichtereinrichtungen (8) jeweilig ein mit den Grundkörper (5) des ersten Kühlkörpers (1) verbundenes, senkrecht zur axialen Richtung (X) der jeweiligen Stromrichtereinrichtung (8) verlaufendes und nach außerhalb der Verschalung führendes erstes Lastparallelanschlusselement (LP1) aufweist, das dem jeweiligen ersten Lastanschlusselement (L1) gegenüberliegend angeordnet ist, wobei die Stromrichtereinrichtungen (8) in einer senkrecht zur axialen Richtung (X) der Stromrichtereinrichtung (8) verlaufenden Reihe hintereinander angeordnet sind und das jeweilige erste Lastanschlusselement (L1) der jeweiligen Stromrichtereinrichtung (8) mit dem jeweiligen ersten Lastparallelanschlusselement (LP1) der unmittelbar in der Reihe nachfolgenden jeweiligen Stromrichtereinrichtung (8) elektrisch leitend verbunden ist.

15. Stromrichteranordnung mit drei Stromrichtereinrichtungen, die nach einem der Ansprüche 1 bis 13 ausgebildet sind, wobei die drei Stromrichtereinrichtungen (8) jeweilig ein mit den Grundkörper (5) des ersten Kühlkörpers (1) verbundenes, senkrecht zur axialen Richtung (X) der jeweiligen Stromrichtereinrichtung (8) verlaufendes und nach außerhalb der Verschalung (13) führendes erstes Lastparallelanschlusselement (LP1) aufweist, das dem jeweiligen ersten Lastanschlusselement (L1) gegenüberliegend angeordnet ist, wobei die drei Stromrichtereinrichtungen (8) auf den Eckpunkten eines gedachten gleichseitigen Dreiecks angeordnet sind, wobei im Uhrzeigersinn das jeweilige erste Lastanschlusselement (L1) der jeweiligen Stromrichtereinrichtung (8) mit dem jeweiligen ersten Lastparallelanschlusselement (LP1) der unmittelbar nachfolgenden jeweiligen Stromrichtereinrichtung (8) elektrisch leitend verbunden ist.

## Claims

1. Power converter device having a first and a second electrically conductive heat sink (1, 2) which are arranged downstream of one another in an axial direction (X) of the power converter device (8), wherein the second heat sink (2) is arranged downstream of the first heat sink (1), wherein the first and second heat sinks (1, 2) respectively have a cylindrical base body (5) and cooling ribs (7) which run in the axial direction (X) of the power converter device (8) and are connected to the base body (5) in a thermally conductive manner,
having a first power semiconductor component (T1) which is arranged between the base bodies (1, 2) of the first and second heat sinks (1, 2),
having a pressure generation device (11) which presses the first and second heat sinks (1, 2) and the first power semiconductor component (T1) against one another,
having a casing (13) which surrounds the cooling ribs (7) of the first and second heat sinks (1, 2) and as such forms a cooling channel (14) in which the cooling ribs (7) of the first and second heat sinks (1, 2) are arranged,
wherein the first heat sink (1) has a first load connection element (L1) which is connected to the base body (5) of the first heat sink (1), runs perpendicular to the axial direction (X) of the power converter device (8) and leads outside the casing (13), wherein the second heat sink (2) has a second load connection element (L2) which is connected to the base body (5) of the second heat sink (2), runs perpendicular to the axial direction (X) of the power converter device (8) and leads outside the casing (13),
**characterized in that** the power converter device has a fan (17) which is designed to move air through the cooling channel (14) along the cooling ribs (7), wherein the base bodies (5) of the first and second heat sinks (1, 2) have a common central axis (A), wherein the casing (13) runs on a circular path running around the respective heat sink (1, 2) in a manner perpendicular to the axial direction (X) of the power converter device (8), wherein the centre point of the circle described by the circular path lies in this case on the central axis (A) of the respective cylindrical base body (5).

2. Power converter device according to Claim 1, **characterized in that** the first heat sink (1) has a first load parallel connection element (LP1) which is connected to the base body (5) of the first heat sink (1), runs perpendicular to the axial direction (X) of the power converter device (8), leads outside the casing (13) and is arranged opposite the first load connection element (L1), and **in that** the second heat sink (2) has a second load parallel connection element (LP2) which is connected to the base body (5) of the second heat sink (2), runs perpendicular to the axial direction (X) of the power converter device (8), leads outside the casing (13) and is arranged opposite the second load connection element (L2).

3. Power converter device according to one of the preceding claims, **characterized in that** the power converter device (8) has an electrically conductive third heat sink (3) which is arranged downstream of the second heat sink (2) in the axial direction (X) of the power converter device (8), wherein the third heat sink (3) has a cylindrical base body (5) and cooling ribs (7) which run in the axial direction (X) of the power converter device (8) and are connected to the base body (5) in a thermally conductive manner, wherein the power converter device (8) has a second power semiconductor component (T2) which is arranged between the base bodies (5) of the second and third heat sinks (2, 3), wherein the pressure generation device (11) presses the first, second and third heat sinks (1, 2, 3) and the first and second power semiconductor components (T1, T2) against one another, wherein the casing (13) surrounds the cooling ribs (5) of the first, second and third heat sinks (1, 2, 3) and as such forms a cooling channel (14) in which the cooling ribs of the first, second and third heat sinks (1, 2, 3) are arranged, wherein the third heat sink (3) has a third load connection element (L3) which is connected to the base body (5) of the third heat sink (3), runs perpendicular to the axial direction (X) of the power converter device (8) and leads outside the casing (13).

4. Power converter device according to Claim 3, **characterized in that** the third heat sink (3) has a third load parallel connection element (LP3) which is connected to the base body (5) of the third heat sink (3), runs perpendicular to the axial direction (X) of the power converter device (8), leads outside the casing (13) and is arranged opposite the third load connection element (L3).

5. Power converter device according to one of the preceding claims, **characterized in that** the first, second and, if present, third heat sink (1, 2, 3) are identical.

6. Power converter device according to one of the preceding claims, **characterized in that** the cooling ribs (7), the load connection elements (L1, L2, L3) and, if present, the load parallel connection elements (LP1, LP2, LP3) of the respective heat sink (1, 2, 3) are formed in one piece with the base body (5) of the respective heat sink (1, 2, 3).

7. Power converter device according to Claim 3 or 4, **characterized in that** the second heat sink (2) is formed from a first and a second partial heat sink (2', 2"), wherein the base body (5) of the second heat sink (2) is formed from a first and a second partial base body (5', 5") and the first partial base body (5') is part of the first partial heat sink (2') and the second partial base body (5") is part of the second partial heat sink (2"), wherein the first and second partial heat sinks (2', 2") are arranged downstream of one another in the axial direction (X) of the power converter device (8), wherein an electrically non-conductive insulation element (26) is arranged between the first and second partial heat sinks (2', 2"), wherein the second load connection element (L2) has multiple pieces and has a first and a second partial load connection element (LT1, LT2), wherein the first partial load connection element (LT1) is connected to the first partial base body (5') and the second partial load connection element (LT2) is connected to the second partial base body (5").

8. Power converter device according to Claim 7, **characterized in that** the power converter device (8) has a second load parallel connection element (LP2) which is connected to the base body (5) of the second heat sink (2), runs perpendicular to the axial direction (X) of the power converter device, leads outside the casing (13) and is arranged opposite the second load connection element (L2), wherein the second load parallel connection element (LP2) has multiple pieces and has a first and a second partial load parallel connection element (LPT1, LPT2), wherein the first partial load parallel connection element (LT1) is connected to the first partial base body (5') and the second partial load parallel connection element (LTP2) is connected to the second partial base body (5").

9. Power converter device according to Claim 7 or 8, **characterized in that** the first and third heat sinks (1, 3) are identical.

10. Power converter device according to Claim 7, 8 or 9, **characterized in that** the first and second partial heat sinks (2', 2") are identical.

11. Power converter device according to one of Claims 7 to 10, **characterized in that** the cooling ribs (7), the load connection elements (L1, L3) and, if present, the load parallel connection elements (LP1, LP3) of the first and third heat sinks (1, 3) are formed in one piece with the base body (5) of the respective heat sink (1, 3), and **in that** the cooling ribs (7) of the first partial heat sink (2'), the first partial load connection element (LT1) and, if present, the first partial load parallel connection element (LTP1) are formed in one piece with the first partial base body (5'), and **in that** the cooling ribs (7) of the second partial heat sink (2"), the second partial load connection element (LT2) and, if present, the second partial load parallel connection element (LTP2) are formed in one piece with the second partial base body (5").

12. Power converter device according to one of the preceding claims, **characterized in that** the casing (13) is formed in multiple pieces from a plurality of casing segments (13').

13. Power converter device according to one of the preceding claims, **characterized in that** the cylindrical base bodies (5) are respectively in the form of hollow cylinders or cylinders consisting of a solid material.

14. Power converter arrangement having a plurality of power converter devices formed according to one of the preceding claims, wherein the power converter devices (8) respectively have a first load parallel connection element (LP1) which is connected to the base body (5) of the first heat sink (1), runs perpendicular to the axial direction (X) of the respective power converter device (8), leads outside the casing and is arranged opposite the respective first load connection element (L1), wherein the power converter devices (8) are arranged downstream of one another in a row running perpendicular to the axial direction (X) of the power converter device (8), and the respective first load connection element (L1) of the respective power converter device (8) is connected in an electrically conductive manner to the respective first load parallel connection element (LP1) of the respective power converter device (8) immediately following in the row.

15. Power converter arrangement having three power converter devices formed according to one of Claims 1 to 13, wherein the three power converter devices (8) respectively have a first load parallel connection element (LP1) which is connected to the base body (5) of the first heat sink (1), runs perpendicular to the axial direction (X) of the respective power converter device (8), leads outside the casing (13) and is arranged opposite the respective first load connection element (L1), wherein the three power converter devices (8) are arranged at the corner points of an imaginary equilateral triangle, wherein the respective first load connection element (L1) of the respective power converter device (8) is connected in an electrically conductive manner to the respective first load parallel connection element (LP1) of the immediately following respective power converter device (8) in the clockwise direction.

## Revendications

1. Dispositif convertisseur de puissance comportant des premier et deuxième dissipateurs thermiques électriquement conducteurs (1, 2) qui sont disposés l'un derrière l'autre dans une direction axiale (X) du dispositif convertisseur de puissance (8), dans lequel le deuxième dissipateur thermique (2) est disposé derrière le premier dissipateur thermique (1), dans lequel les premier et deuxième dissipateurs thermiques (1, 2) comportent chacun un corps de base cylindrique (5) et des ailettes de refroidissement (7) s'étendant dans la direction axiale (X) du dispositif convertisseur de puissance (8) et qui sont reliées de manière thermiquement conductrice au corps de base (5),
comportant un premier composant semi-conducteur de puissance (T1) disposé entre les corps de base (1, 2) des premier et deuxième dissipateurs thermiques (1, 2), comportant un dispositif générateur de pression (11) comprimant l'un contre l'autre les premier et deuxième dissipateurs thermiques (1, 2) et le premier composant semi-conducteur de puissance (T1),
comportant une enveloppe (13) qui entoure les ailettes de refroidissement (7) des premier et deuxième dissipateurs thermiques (1, 2) et forme ainsi un canal de refroidissement (14) dans lequel sont disposées les ailettes de refroidissement (7) des premier et deuxième dissipateurs thermiques (1, 2), dans lequel le premier dissipateur thermique (1) comporte un premier élément de raccordement de charge (L1) qui est relié au corps de base (5) du premier dissipateur thermique (1), s'étend perpendiculairement à la direction axiale (X) du dispositif convertisseur de puissance (8) et mène à l'extérieur du boîtier (13), dans lequel le deuxième dissipateur thermique (2) comporte un deuxième élément de raccordement de charge (L2) qui est relié au corps de base (5) du deuxième dissipateur thermique (2), s'étend perpendiculairement à la direction axiale (X) du dispositif de convertisseur de puissance (8) et mène à l'extérieur du boîtier (13),
**caractérisé en ce que** le dispositif convertisseur de puissance comporte un ventilateur (17) conçu pour faire circuler de l'air à travers le canal de refroidissement (14) le long des ailettes de refroidissement (7), dans lequel les corps de base (5) des premier et deuxième dissipateurs thermiques (1, 2) présentent un axe central commun (A), dans lequel l'enveloppe (13) s'étend sur un trajet circulaire passant autour du dissipateur thermique respectif (1, 2) perpendiculairement à la direction axiale (X) du dispositif convertisseur de puissance (8), dans lequel le centre du cercle qui définit le trajet circulaire se situe ainsi sur l'axe central (A) du corps de base cylindrique respectif (5).

2. Dispositif convertisseur de puissance selon la revendication 1, **caractérisé en ce que** le premier dissipateur thermique (1) comporte un premier élément de raccordement parallèle de charge (LP1) qui est relié au corps de base (5) du premier dissipateur thermique (1), s'étend perpendiculairement à la direction axiale (X) du dispositif convertisseur de puissance (8) et mène à l'extérieur du boîtier (13) et qui est disposé en face du premier élément de raccordement de charge (L1), et **en ce que** le deuxième dissipateur thermique (2) comporte un deuxième élément de raccordement parallèle de charge (LP2) qui est relié au corps de base (5) du deuxième dissipateur thermique (2), s'étend perpendiculairement à la direction axiale (X) du dispositif convertisseur de puissance (8), et mène à l'extérieur du boîtier (13) et qui est disposé en face du deuxième élément de raccordement de charge (L2).

3. Dispositif convertisseur de puissance selon l'une des revendications précédentes, **caractérisé en ce que** le dispositif convertisseur de puissance (8) comporte un troisième dissipateur thermique électriquement conducteur (3) qui est disposé derrière le deuxième dissipateur thermique (2) dans la direction axiale (X) du dispositif convertisseur de puissance (8), dans lequel le troisième dissipateur thermique (3) comporte un corps de base cylindrique (5) et des ailettes de refroidissement (7) s'étendant dans la direction axiale (X) du dispositif de conversion de puissance (8) et reliées thermiquement au corps de base (5), dans lequel le dispositif convertisseur de puissance (8) comporte un deuxième composant semi-conducteur de puissance (T2) qui est disposé entre les corps de base (5) des deuxième et troisième dissipateurs thermiques (2, 3), dans lequel le dispositif générateur de pression (11) comprime les uns contre les autres les premier, deuxième et troisième dissipateurs thermiques (1, 2, 3) et les premier et deuxième composants semi-conducteurs de puissance (T1, T2), dans lequel l'enveloppe (13) entoure les ailettes de refroidissement (5) des premier, deuxième et troisième dissipateurs thermiques (1, 2, 3) et forme ainsi un canal de refroidissement (14) dans lequel sont disposées les ailettes de refroidissement des premier, deuxième et troisième dissipateurs thermiques (1, 2, 3), dans lequel le troisième dissipateur thermique (3) comporte un troisième élément de raccordement de charge (L3) qui est relié au corps de base (5) du troisième dissipateur thermique (3), s'étend perpendiculairement à la direction axiale (X) du dispositif convertisseur de puissance (8) et mène à l'extérieur du boîtier (13).

4. Dispositif convertisseur de puissance selon la revendication 3, **caractérisé en ce que** le troisième dissipateur thermique (3) comporte un troisième élément de raccordement parallèle de charge (LP3) qui est relié au corps de base (5) du troisième dissipateur thermique (3), s'étend perpendiculairement à la direction axiale (X) du dispositif convertisseur de puissance (8) et mène à l'extérieur du boîtier (13) et qui est disposé en face du troisième élément de raccordement de charge (L3).

5. Dispositif convertisseur de puissance selon l'une des revendications précédentes, **caractérisé en ce que** les premier, deuxième et, le cas échéant, troisième dissipateurs thermiques (1, 2, 3) sont conçus de manière identique.

6. Dispositif de convertisseur de puissance selon l'une des revendications précédentes, **caractérisé en ce que** les ailettes de refroidissement (7), les éléments de raccordement de charge (L1, L2, L3) et, le cas échéant, les éléments de raccordement parallèle de charge (LP1, LP2, LP3) du dissipateur thermique respectif (1, 2, 3) sont réalisés en une seule pièce avec le corps de base (5) du dissipateur thermique respectif (1, 2, 3).

7. Dispositif convertisseur de puissance selon la revendication 3 ou 4, **caractérisé en ce que** le deuxième dissipateur thermique (2) est constitué d'un premier et d'un deuxième dissipateur thermique partiel (2', 2"), dans lequel le corps de base (5) du deuxième dissipateur thermique (2) est constitué d'un premier et d'un deuxième corps de base partiel (5', 5"), **en ce que** le premier corps de base partiel (5') fait partie du premier dissipateur thermique partiel (2') et **en ce que** le deuxième corps de base partiel (5") fait partie du deuxième dissipateur thermique partiel (2"), dans lequel les premier et deuxième dissipateurs thermiques partiels (2', 2") sont disposés l'un derrière l'autre dans la direction axiale (X) du dispositif convertisseur de puissance (8), dans lequel un élément d'isolation électriquement non conducteur (26) est disposé entre les premier et deuxième dissipateurs thermiques partiels (2', 2"), dans lequel le deuxième élément de raccordement de charge (L2) est constitué de plusieurs pièces et comporte des premier et deuxième éléments de raccordement de charge partiels (LT1, LT2), dans lequel le premier élément de raccordement de charge partiel (LT1) est relié au premier corps de base partiel (5') et le deuxième élément de raccordement de charge partiel (LT2) est relié au deuxième corps de base partiel (5").

8. Dispositif convertisseur de puissance selon la revendication 7, **caractérisé en ce que** le dispositif convertisseur de puissance (8) comporte un deuxième élément de raccordement parallèle de charge (LP2) qui est relié au corps de base (5) du deuxième dissipateur thermique (2), s'étend perpendiculairement à la direction axiale (X) du dispositif convertisseur de puissance et mène à l'extérieur du boîtier (13) et qui est disposé en face du deuxième élément de raccordement de charge (L2), dans lequel le deuxième élément de raccordement parallèle de charge (LP2) est constitué de plusieurs pièces et comporte des premier et deuxième éléments de raccordement parallèle de charge partiels (LPT1, LPT2), dans lequel le premier élément de raccordement parallèle de charge partiel (LT1) est relié au premier corps de base partiel (5') et le deuxième élément de raccordement parallèle de charge partiel (LTP2) est relié au deuxième corps de base partiel (5").

9. Dispositif convertisseur de puissance selon la revendication 7 ou 8, **caractérisé en ce que** les premier et troisième dissipateurs thermiques (1, 3) sont conçus de manière identique.

10. Dispositif convertisseur de puissance selon la revendication 7, 8 ou 9, **caractérisé en ce que** les premier et deuxième dissipateurs thermiques partiels (2', 2") sont conçus de manière identique.

11. Dispositif de conversion de puissance selon l'une des revendications 7 à 10, **caractérisé en ce que** les ailettes de refroidissement (7), les éléments de raccordement de charge (L1, L3) et, le cas échéant, les éléments de raccordement parallèle de charge (LP1 , LP3) des premier et troisième dissipateurs thermiques (1, 3) sont réalisés en une seule pièce avec le corps de base (5) du dissipateur thermique respectif (1, 3), et **en ce que** les ailettes de refroidissement (7) du premier dissipateur thermique partiel (2'), le premier élément de raccordement de charge partiel (LT1) et, le cas échéant, le premier élément de raccordement parallèle de charge partiel (LTP1) sont réalisés en une seule pièce avec le premier corps de base partiel (5'), et **en ce que** les ailettes de refroidissement (7) du deuxième dissipateur thermique partiel (2"), le deuxième élément de raccordement de charge partiel (LT2) et, le cas échéant, le deuxième élément de raccordement parallèle de charge partiel (LTP2) sont réalisés en une seule pièce avec le deuxième corps de base partiel (5").

12. Dispositif convertisseur de puissance de l'une des revendications précédentes, **caractérisé en ce que** l'enveloppe (13) est réalisée en plusieurs pièces à partir d'une pluralité de segments d'enveloppe (13').

13. Dispositif convertisseur de puissance selon l'une des revendications précédentes, **caractérisé en ce que** les corps de base cylindriques (5) sont chacun réalisés sous la forme de cylindres creux ou de cylindres constitués d'un matériau solide.

14. Système convertisseur de puissance comportant une pluralité de dispositifs convertisseurs de puissance qui sont réalisés selon l'une des revendications précédentes, dans lequel les dispositifs convertisseurs de puissance (8) comportent chacun un premier élément de raccordement parallèle de charge (LP1) qui est relié au corps de base (5) du premier dissipateur thermique (1), s'étend perpendiculairement à la direction axiale (X) du dispositif convertisseur de puissance respectif (8) et mène à l'extérieur du boîtier et qui est disposé en face du premier élément de raccordement de charge respectif (L1), dans lequel les dispositifs convertisseurs de puissance (8) sont disposés l'un derrière l'autre dans une rangée s'étendant perpendiculairement à la direction axiale (X) du convertisseur de puissance (8) et le premier élément de raccordement de charge respectif (L1) du dispositif convertisseur de puissance respectif (8) est relié de manière électriquement conductrice au premier élément de raccordement parallèle de charge respectif (LP1) du dispositif convertisseur de puissance respectif (8) immédiatement consécutif dans la rangée.

15. Système convertisseur de puissance comportant trois dispositifs convertisseurs de puissance qui sont réalisés selon l'une des revendications 1 à 13, dans lequel les trois dispositifs convertisseurs de puissance (8) comportent chacun un premier élément de raccordement parallèle de charge (LP1) qui est relié au corps de base (5) du premier dissipateur thermique (1), s'étend perpendiculairement à la direction axiale (X) du dispositif convertisseur de puissance respectif (8) et mène à l'extérieur du boîtier (13) et qui est disposé en face du premier élément de raccordement de charge respectif (L1), dans lequel les trois dispositifs convertisseurs de puissance (8) sont disposés aux sommets d'un triangle équilatéral imaginaire, dans lequel le premier élément de raccordement de charge respectif (L1) du dispositif convertisseur de puissance respectif (8) est relié de manière électriquement conductrice dans le sens horaire au premier élément de raccordement parallèle de charge respectif (LP1) du dispositif convertisseur de puissance respectif (8) immédiatement consécutif.
